# EUROPÄISCHE PATENTSCHRIFT

(11) **EP 2 589 272 B1**
(45) Veröffentlichungstag und Bekanntmachung des Hinweises auf die Patenterteilung: **17.05.2017**
(21) Anmeldenummer: 11729910.7
(22) Anmeldetag: 20.06.2011
(51) Int. Cl.: H05K 5/02, F21V 31/03

(54) **ANORDNUNG UND GERÄT MIT EINER ANORDNUNG ZUM ENTLÜFTEN EINES RAUMBEREICHS**
ARRANGEMENT AND DEVICE HAVING AN ARRANGEMENT FOR VENTING A SPATIAL AREA
ENSEMBLE ET APPAREIL DOTÉ D'UN ENSEMBLE POUR VENTILER UNE ZONE COMPARTIMENT

(30) Priorität: 02.07.2010 DE 102010025980
(43) Veröffentlichungstag der Anmeldung: 08.05.2013
(73) Patentinhaber: Sew-Eurodrive GmbH & Co. KG, 76646 Bruchsal (DE)
(72) Erfinder: KERSCHBAUM, Martin, 76139 Karlsruhe (DE)
(74) Vertreter: Tüngler, Eberhard
(86) Internationale Anmeldenummer: PCT/EP2011/003036
(87) Internationale Veröffentlichungsnummer: WO 2012/000623

(56) Entgegenhaltungen:
- EP-A1- 1 997 685
- DE-B3- 10 349 543
- DE-U1-202006 008 917
- US-B1- 6 524 361

## Beschreibung

Die Erfindung betrifft eine Anordnung und ein Gerät mit einer Anordnung zum Entlüften eines Raumbereichs.

Entlüftungsmittel mit semipermeabler Membran sind bekannt.

Aus der EP 1 997 685 A1 ist als nächstliegender Stand der Technik eine Anordnung nach dem Oberbegriff von Anspruch 1 bekannt, mit einer Entlüftung mit Membranen die auf rechteckförmigen fensterartigen Ausnehmungen eines Teils mit Entlüftungskanal angebracht sind.

Aus der DE 103 49 543 B3 ist ein Verschlussstopfen für ein elektronisches Gerät oder für einen Elektromotor bekannt, der ebenfalls eine klebeverbundene Membran aufweist.

Aus der DE 103 49 543 B3 ist ein einschraubbarer Verschlussstopfen mit Entlüftungskanal bekannt

Aus der US 6 524 361 B1 ist ein Andrücken einer Membran mittels eines Rings gezeigt.

Der Erfindung liegt daher die Aufgabe zugrunde, ein Entlüftungsmittel weiterzubilden, wobei ein flexibler Einsatz ermöglicht werden soll.

Erfindungsgemäß wird die Aufgabe bei der Anordnung zum Entlüften eines Raumbereichs nach den in Anspruch 1 und bei dem Gerät nach den in Anspruch 11 angegebenen Merkmalen gelöst.

Wichtige Merkmale der Erfindung bei der Anordnung nach Anspruch 1 sind, dass sie zum Entlüften eines Raumbereichs vorgesehen ist,
wobei die Anordnung ein Entlüftungsmittel aufweist,
wobei das Entlüftungsmittel einen Entlüftungskanal, insbesondere Hohlraumbereich, aufweist, der an seinem ersten Endbereich in den Raumbereich mündet,
wobei der Entlüftungskanal zumindest zwei weitere Endbereiche aufweist,
wobei ein erster der weiteren Endbereiche an einem ersten Oberflächenbereich des Entlüftungsmittels in eine Mündungsöffnung mündet,
wobei ein zweiter der weiteren Endbereiche an einem zweiten Oberflächenbereich des Entlüftungsmittels in eine Mündungsöffnung mündet,
wobei erster und zweiter Oberflächenbereich verschiedene Orientierungen aufweisen, insbesondere also die Mündungsöffnungen in verschiedene Richtungen weisen,
insbesondere wobei die Richtungen entgegengesetzt ausgerichtet sind.

Von Vorteil ist dabei, dass bei beliebiger Einbaulage des Entlüftungsmittels stets eine Entlüftung gewährleistbar ist. Außerdem ist ein Schutz gegen Spritzwasser vorhanden. Somit ist ein flexibler Einsatz erreicht. Denn das Entlüftungsmittel ist in Nassbereichen oder Spritzwasserbereichen in jeder Einbaulage einsetzbar.

Bei einer vorteilhaften Ausgestaltung sind die Mündungsöffnungen mittels einer jeweiligen semipermeablen Membran abgedeckt. Von Vorteil ist dabei, dass Flüssigkeiten abweisbar sind, wobei jedoch Unterschiede im Luftdruck zwischen Raumbereich und äußerer Umgebung ausgleichbar sind
Bei einer vorteilhaften Ausgestaltung sind die Membranen und/oder Mündungsöffnungen parallel ausgerichtet. Von Vorteil ist dabei, dass bei Zusetzen einer der Mündungsöffnungen durch eingedrungene Flüssigkeit oder beispielsweise Kondenswasser, die andere Membran nicht zugesetzt ist.

Bei einer vorteilhaften Ausgestaltung ist der Entlüftungskanal aus einer Längsbohrung und einer Querbohrung gebildet. Von Vorteil ist dabei, dass der Kanal in einfacher Weise fertigbar ist und auf diese Weise zwei zur Umgebung hin führende Endbereiche aufweist.

Bei einer vorteilhaften Ausgestaltung ist der Entlüftungskanal T-förmig ausgeprägt. Von Vorteil ist dabei, dass eine einfache Herstellung ermöglicht ist.

Bei einer vorteilhaften Ausgestaltung weist die Anordnung eine Schutzkappe auf, die auf das Entlüftungsmittel aufsetzbar und formschlüssig und/oder kraftschlüssig verbindbar ist. Von Vorteil ist dabei, dass Spritzwasser oder sonstige mit Druck aufgebrachte Flüssigkeit nicht direkt auf die Membran sondern nur über einen gewinkelten Verlauf, also mit Umlenkungen, zur Membran gelangen kann. Somit ist der Druck vermindert und die Membran geschützt.

Bei einer vorteilhaften Ausgestaltung ist die Schutzkappe im Wesentlichen ein Rotationskörper. Von Vorteil ist dabei, dass eine einfache Herstellung ermöglicht ist.

Bei einer vorteilhaften Ausgestaltung ist der erste und zweite Oberflächenbereich jeweils eine Auflagefläche für die Membran, insbesondere eine plane Auflagenfläche für die Membran. Von Vorteil ist dabei, dass die Membran einfach befestigbar ist, insbesondere mittels eines ringförmigen Teils, mit welchem die Membran anpressbar ist. Die Auflagefläche ist bei Herstellung bearbeitet, insbesondere gefräst und/oder geschliffen bearbeitet. Somit ist die Membran dicht und ohne Beschädigung anpressbar.

Bei einer vorteilhaften Ausgestaltung sind erster und zweiter Oberflächenbereich in einem abgeflachten Bereich angeordnet, so dass erster und zweiter Oberflächenbereich von der Schutzkappe, insbesondere von deren Innenfläche, beabstandet sind,
insbesondere wobei die Schutzkappe auf das Entlüftungsmittel aufgesetzt und berührend verbunden ist, insbesondere auf einen Entlüftungsabschnitt, in welchem der abgeflachte Bereich angeordnet ist. Von Vorteil ist dabei, dass die Schutzkappe berührend verbindbar ist und trotzdem ein Durchlass für Luft zum Ausgleich von Druckunterschieden zwischen Raumbereich und Umgebung ausführbar ist.

Bei einer vorteilhaften Ausgestaltung ist der Raumbereich zumindest teilweise von einem Gehäuseteil begrenzt und das Entlüftungsmittel ist in und/oder an einer Ausnehmung des Gehäuseteils angeordnet. Von Vorteil ist dabei, dass das Entlüftungsmittel eine Verschlussschraube ersetzend in die Ausnehmung des Gehäuseteils verbindbar, insbesondere mittels Presspassung oder Schraubverbindung, ist.

Bei einer vorteilhaften Ausgestaltung weist das Entlüftungsmittel einen Verbindungsbereich auf, mit dem es in einer Ausnehmung des Gehäuseteils kraftschlüssig und/oder formschlüssig verbindbar ist, insbesondere wobei der Verbindungsbereich ein Gewindebereich ist und die Ausnehmung eine Gewindebohrung, so dass das Entlüftungsmittel im Gehäuseteil schraubverbindbar ist. Von Vorteil ist dabei, dass eine dichte und lösbare Verbindung mit dem Gehäuseteil ausführbar ist.

Bei einer vorteilhaften Ausgestaltung weist die Anordnung eine Dichtung auf, die zwischen Entlüftungsmittel und Gehäuseteil anordenbar ist zur dichten Verbindung des Entlüftungsmittels mit dem Gehäuseteil. Von Vorteil ist dabei, dass eine dichte Verbindung herstellbar ist.

Bei einer vorteilhaften Ausgestaltung umgibt die Schutzkappe den ersten und zweiten Oberflächenbereich beziehungsweise die Mündungsbereiche, wobei die Schutzkappe von diesen Bereichen beabstandet ist. Von Vorteil ist dabei, dass die Bereiche geschützt sind gegen aufgespritztes Wasser und somit die Membranen geschützt angeordnet sind.

Bei einer vorteilhaften Ausgestaltung weist die Schutzkappe eine zentral, also mittig angeordnete Ausnehmung auf. Von Vorteil ist dabei, dass die Schutzkappe einfach herstellbar ist. Außerdem ist eine vom Eingriffsbereich 2 abgewandte Öffnung vorsehbar, so dass ein Abfließen von Flüssigkeit einfach erfolgt. Denn die Öffnung ist somit weit entfernt von dem zwischen Entlüftungsmittel, insbesondere Eingriffsbereich, und Schutzkappe angeordnetem Durchlass.

Wichtige Merkmale bei dem Gerät sind, dass das Entlüftungsmittel mit einem Gehäuseteil des Geräts formschlüssig und/oder kraftschlüssig verbunden ist,
insbesondere wobei das Entlüftungsmittel in einer Ausnehmung einer Wand des Gehäuseteils anordenbar und/oder verbindbar ist.

Von Vorteil ist dabei, dass ein Gerät entlüftbar ist, ohne dass Wasser eindringt. Insbesondere ist der Luftdruckunterschied ausgleichbar und bei eventuell im Gerät auftretenden Kondenswasser eine Entlüftung, also ein Abführen feuchter Luft an die Umgebung, ausführbar.

Das Gerät ist beispielsweise eine Elektrogerät, wie Umrichter, Sanftanlaufgerät, Steuerung oder dergleichen. Es ist als Gerät aber auch ein Elektromotor und/oder ein Getriebe verwendbar, das sogar mit Schmierstoff teilweise gefüllt ist.

Weitere Vorteile ergeben sich aus den Unteransprüchen.

Die Erfindung wird nun anhand von Abbildungen näher erläutert:

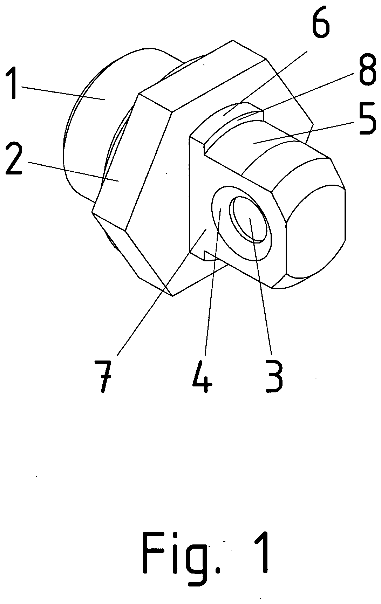

In der Figur 1 ist eine Schrägansicht auf das Entlüftungsmittel ohne Schutzkappe 20 gezeigt.

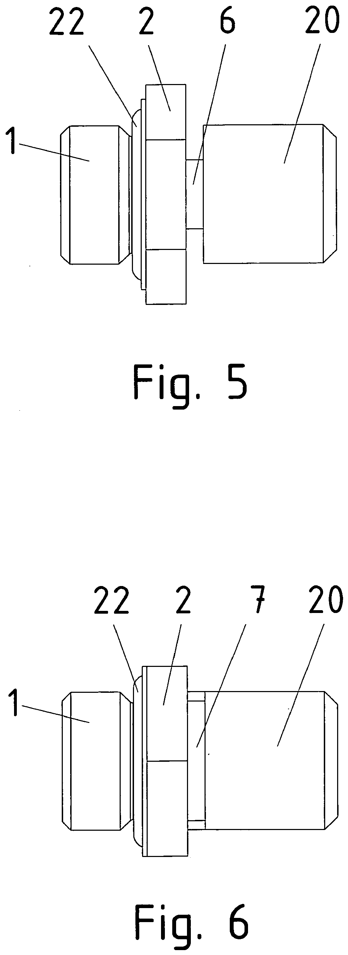

In der Figur 2 ist ein zugehöriger Querschnitt in B-B Richtung bei aufgesetzter Schutzkappe 20 gezeigt, wobei Figur 6 im oberen Teil ohne Bezugszeichen eingeblendet dargestellt ist.

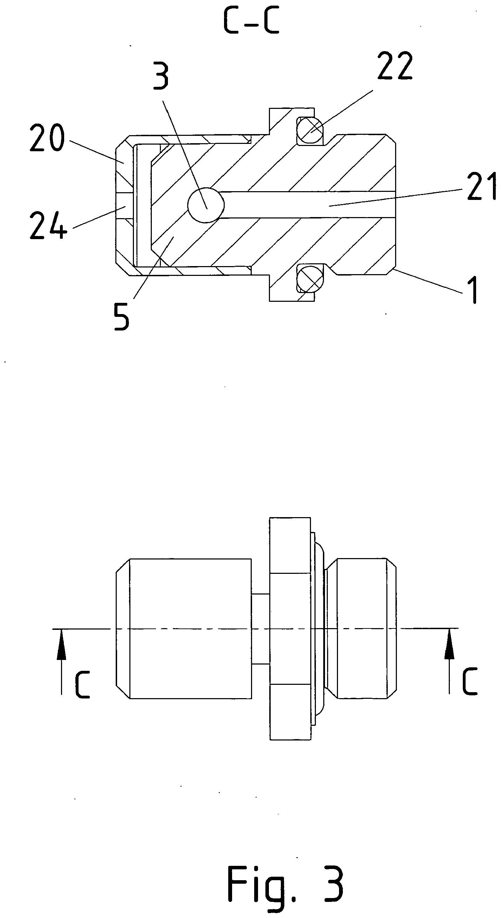

In der Figur 3 ist ein anderer Querschnitt in C-C -Richtung bei aufgesetzter Schutzkappe 20 gezeigt, wobei Figur 5 im unteren Teil ohne Bezugszeichen eingeblendet dargestellt ist.

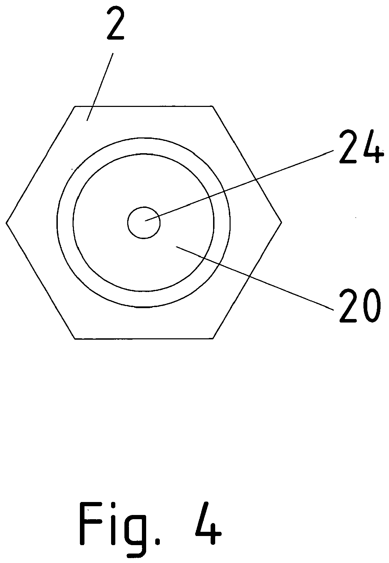

In der Figur 4 ist eine Draufsicht auf die Schutzkappe 20 gezeigt.

In der Figur 5 ist eine Seitenansicht aus einer ersten Blickrichtung gezeigt.

In Figur 6 ist eine weitere Seitenansicht aus einer zur ersten senkrecht ausgerichteten Blickrichtung gezeigt
Das Entlüftungsmittel weist einen Verbindungsbereich 1 auf, mit dem es in die Ausnehmung eines Gehäuseteils eines Geräts einbringbar und verbindbar ist. Beispielsweise ist der Verbindungsbereich als glatte zylindrische Fläche ausbildbar und somit in eine hohlzylindrisch ausgeführte Ausnehmung, wobei dann ein kraftschlüssiges dichtes Verbinden ausführbar ist. Alternativ ist der Verbindungsbereich 1 als Gewindeabschnitt ausgeführt, womit das Entlüftungsmittel in eine Gewindebohrung eines Gehäuseteils einschraubbar ist.

Das Entlüftungsmittel ist somit in die Gewindebohrung eines Gehäuseteils einschraubbar und kann somit beispielsweise eine Verschlussschraube ersetzen.

Zum dichten Verbinden ist hierbei eine Dichtung 22 zwischen Verbindungsbereich 1 und Eingriffsbereich 2 für Werkzeug, insbesondere Außensechskantabschnitt, vorgesehen.

Das Entlüftungsmittel weist auch einen Eingriffsbereich 2 für Werkzeug auf, das vorzugsweise als Außensechskantabschnitt ausgeführt ist. Somit ist eine Drehbewegung beim Verbinden mit dem Gehäuseteil mittels Werkzeug bewirkbar.

Das Entlüftungsmittel weist einen Entlüftungsabschnitt 5 auf, auf den eine Schutzkappe 20 aufsteckbar und verbindbar ist. Der Entlüftungsabschnitt 5 weist eine Querbohrung 3 auf, die an ihren beiden Endbereichen in jeweils eine Auflagefläche 4 für semipermeable Membran mündet.

Außerdem ist der Entlüftungsabschnitt 5 aus einem zylindrischen Rohguss-Vorsprung hergestellt bei der Bearbeitung. Hierbei weist er einen ringartigen Vorsprung 6 auf, mit dem er den Eingriffsbereich 2 mit dem Entlüftungsabschnitt 5 verbindet.

Der Entlüftungsabschnitt 5 weist eine Abflachung 7 auf, so dass nach Aufsetzen der als Rotationskörper ausgeführten, also rotationssymmetrisch geformten Schutzkappe 20 ein Durchlass für Luft entsteht. Somit kann zwar Außenluft bis zur semipermeablen Membran gelangen, sie muss aber quer zur Normalenrichtung der Abflachung einströmen. Somit kann aufgespritzte Flüssigkeit nicht direkt und somit nicht mit hohem Druck an die semipermeable Membran gelangen sondern nur auf einem gewinkelten Weg, also druckvermindert.

Die Schutzkappe 20 sitzt auf einer Stufe 8 des Entlüftungsabschnitts 5 auf.

Der Entlüftungsabschnitt 5 weist eine Längsbohrung 21 auf, die mittig, also zentral, angeordnet ist und in die Querbohrung 3 mündet, insbesondere in deren Zentrum. An ihrem anderen Ende mündet die Längsbohrung 21 in den vom Gehäuseteil umschlossenen Raumbereich.

An den Auflageflächen 4 sind jeweils semipermeable Membrane 23 vorgesehen. Dabei sind die Auflageflächen 4 und somit auch die Membrane 23 parallel zueinander angeordnet. Die Querbohrung ist sozusagen beidseitig, also an ihren Endbereichen, abgedeckt von einer jeweiligen semipermeablen Membran 23. Die Membran ist vorzugsweise als Goretech ausgeführt.

Die Schutzkappe weist eine Ausnehmung 24 auf, die zentral, also rotationssymmetrisch angeordnet ist. Beispielsweise ist hierbei auch eine Durchgangs-Bohrung durch die Schutzkappe 20 als Ausnehmung 24 verwendbar.

Somit kann zwischen Schutzkappe 20 und Entlüftungsabschnitt 5 eingedrungenes Wasser nicht anstehen, sondern fließt ab, da der Durchlass und die Ausnehmung 24 ein Abfließen abhängig von der Einbaulage des Entlüftungsmittels bewirken.

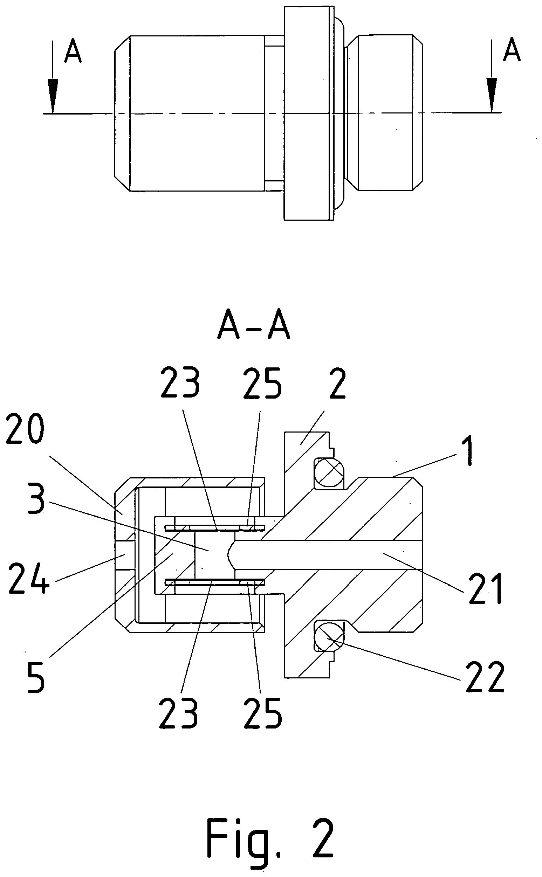

Der Durchlass ist in Figur 2 besonders gut ersichtlich, da dort zwischen Membran 23 und Schutzkappe 20 ein freier Raumbereich sichtbar ist, der nach unten in den Außenbereich mündet. Nach oben ist er mit der Ausnehmung 24 in der Schutzkappe 20 verbunden und somit auch hier mit dem Außenbereich verbunden. Im nicht abgeflachten Bereich ist die Schutzkappe 20 berührend auf den Entlüftungsabschnitt aufgesetzt.

Vorzugsweise ist die Schutzkappe derart dünn und aus einem derartigen Material ausgeführt, dass bei Aufsetzen auf den Entlüftungsabschnitt 5 eine kraftschlüssige Verbindung wegen der elastischen Verformung der Schutzkappe 20 entsteht. Der Entlüftungsabschnitt 5 ist aus einem weniger elastisch verformbaren Material gefertigt, beispielsweise Metall, wie Stahl oder Aluminium. Die Schutzkappe 20 ist beispielsweise aus einem Kunststoff oder einem dünnen Stahlblech gefertigt.

Wenn nun die Einbaulage derart gewählt ist, dass eine Flüssigkeit, wie Wasser, an einer der Auflageflächen 4 ansteht, ist zumindest die andere Membran frei von der Flüssigkeit.

Mittels der beiden Membranen 23, die parallel und voneinander beabstandet angeordnet sind, ist also stets eine Entlüftung eines vom Gehäuseteil umschlossenen Raumbereichs gewährleistet. Eine Kondenswasserbildung im Raumbereich ist also verhinderbar mittels des Entlüftungsmittels.

Die Membran 23 wird auf die Auflagefläche aufgelegt und von einem ösenartigen Ringteil 25, insbesondere von dessen Randbereich, gegen die Auflagefläche gedrückt. Das Ringteil 5 ist vorzugsweise aus einem Blech gefertigt und ein Loch ist ausgestanzt. Das Loch ist mittig zur Querbohrung angeordnet. Somit ist ein Durchströmen der Luft durch das Ringteil 25 zur Membran ungehindert ermöglicht.

Die Membran 23 ist für Flüssigkeiten, wie Wasser und/oder Öl, undurchlässig. Sie ist aber durchlässig für Luft.

In einem weiteren erfindungsgemäßen Ausführungsbeispiel wird die Membran 23 auf die Auflagefläche aufgelegt und verklebt.

### Bezugszeichenliste

- 1: Verbindungsbereich, insbesondere Gewindeabschnitt
- 2: Eingriffsbereich für Werkzeug, insbesondere Außensechskantabschnitt
- 3: Querbohrung
- 4: Auflagefläche für semipermeable Membran
- 5: Entlüftungsabschnitt
- 6: ringartiger Vorsprung
- 7: Abflachung
- 8: Stufe
- 20: Schutzkappe
- 21: Längsbohrung
- 22: Dichtung
- 23: semipermeable Membran
- 24: Ausnehmung
- 25: Ring, ringartiges Teil, ösenartiges Ringteil

## Patentansprüche

1. Anordnung zum Entlüften eines Raumbereichs,
wobei die Anordnung ein Entlüftungsmittel aufweist,
wobei das Entlüftungsmittel (3, 21) einen Entlüftungskanal, insbesondere Hohlraumbereich, aufweist, der an seinem ersten Endbereich in den Raumbereich mündet,
wobei der Entlüftungskanal zumindest zwei weitere Endbereiche aufweist,
wobei ein erster der weiteren Endbereiche an einem ersten Oberflächenbereich des Entlüftungsmittels in eine Mündungsöffnung mündet,
wobei ein zweiter der weiteren Endbereiche an einem zweiten Oberflächenbereich des Entlüftungsmittels in eine Mündungsöffnung mündet,
wobei erster und zweiter Oberflächenbereich verschiedene Orientierungen aufweisen, insbesondere also die Mündungsöffnungen in verschiedene Richtungen weisen, insbesondere wobei die Richtungen entgegengesetzt ausgerichtet sind,
wobei der Entlüftungskanal T-förmig ausgeprägt ist,
**dadurch gekennzeichnet, dass**
der Entlüftungskanal aus einer einzigen Längsbohrung und einer einzigen Querbohrung gebildet ist,
der Raumbereich zumindest teilweise von einem Gehäuseteil begrenzt ist,
wobei das Entlüftungsmittel einen Verbindungsbereich aufweist, mit dem es in einer Ausnehmung des Gehäuseteils kraftschlüssig und/oder formschlüssig verbindbar ist,
wobei der Verbindungsbereich ein Gewindebereich ist und die Ausnehmung eine Gewindebohrung, so dass das Entlüftungsmittel im Gehäuseteil schraubverbindbar ist,
wobei die Anordnung eine Dichtung (22) aufweist, die zwischen Entlüftungsmittel und
Gehäuseteil anordenbar ist zur dichten Verbindung des Entlüftungsmittels mit dem Gehäuseteil,
wobei der erste und zweite Oberflächenbereich jeweils eine Auflagefläche (4) insbesondere eine ebene Auflagefläche, für eine jeweilige Membran ist,
wobei die jeweilige Membran (23) auf die jeweilige Auflagefläche aufgelegt ist und von einem Randbereich eines jeweiligen ösenartigen Ringteils (25) gegen die jeweilige Auflagefläche gedrückt ist,
wobei eine Schutzkappe (20) auf einer Stufe (8) eines Entlüftungsabschnitts (5) aufsitzt.

2. Anordnung nach Anspruch 1, **dadurch gekennzeichnet, dass**
die Mündungsöffnungen mittels einer jeweiligen semipermeablen Membran abgedeckt sind.

3. Anordnung nach mindestens einem der vorangegangenen Ansprüche,
**dadurch gekennzeichnet, dass**
die Membranen und/oder Mündungsöffnungen parallel ausgerichtet sind.

4. Anordnung nach mindestens einem der vorangegangenen Ansprüche,
**dadurch gekennzeichnet, dass**
die Anordnung eine Schutzkappe aufweist, die auf das Entlüftungsmittel formschlüssig und/oder kraftschlüssig verbindbar ist.

5. Anordnung nach mindestens einem der vorangegangenen Ansprüche,
**dadurch gekennzeichnet, dass**
die Schutzkappe im Wesentlichen ein Rotationskörper ist.

6. Anordnung nach mindestens einem der vorangegangenen Ansprüche, **dadurch gekennzeichnet, dass**
erster und zweiter Oberflächenbereich in einem abgeflachten Bereich angeordnet sind, so dass erster und zweiter Oberflächenbereich von der Schutzkappe, insbesondere von deren Innenfläche, beabstandet sind,
insbesondere wobei die Schutzkappe auf das Entlüftungsmittel aufgesetzt und berührend verbunden ist, insbesondere auf einen Entlüftungsabschnitt, in welchem der abgeflachte Bereich angeordnet ist.

7. Anordnung nach mindestens einem der vorangegangenen Ansprüche,
**dadurch gekennzeichnet, dass**
das Entlüftungsmittel in einer Ausnehmung des Gehäuseteils angeordnet ist.

8. Anordnung nach mindestens einem der vorangegangenen Ansprüche,
**dadurch gekennzeichnet, dass**
die Schutzkappe den ersten und zweiten Oberflächenbereich beziehungsweise die Mündungsbereiche umgibt, wobei die Schutzkappe von diesen Bereichen beabstandet ist.

9. Anordnung nach mindestens einem der vorangegangenen Ansprüche,
**dadurch gekennzeichnet, dass**
die Schutzkappe eine zentral, also mittig angeordnete Ausnehmung aufweist.

10. Gerät mit einer Anordnung nach mindestens einem der vorangegangenen Ansprüche, **dadurch gekennzeichnet, dass**
das Entlüftungsmittel mit einem Gehäuseteil des Geräts formschlüssig und/oder kraftschlüssig verbunden ist,
wobei das Entlüftungsmittel in einer Ausnehmung einer Wand des Gehäuseteils anordenbar und/oder verbindbar ist.

## Claims

1. An arrangement for the ventilation of a spatial area,
wherein the arrangement has a ventilation means,
wherein the ventilation means (3, 21) has a ventilation channel, in particular a hollow spatial area, which at its first end region opens into the spatial area,
wherein the ventilation channel has at least two further end regions,
wherein a first of the further end regions opens at a first surface region of the ventilation means into a mouth opening,
wherein a second of the further end regions opens at a second surface region of the ventilation means into a mouth opening,
wherein first and second surface region have different orientations, in particular therefore the mouth openings are directed in different directions, in particular wherein the directions are oriented in different directions,
wherein the ventilation channel is formed T-shaped,
**characterised in that**
the ventilation channel is formed from a single longitudinal bore and a single transverse bore, the spatial area is at least partially bounded by a housing part,
wherein the ventilation means has a connection region with which it is connectable in a cutout of the housing part in a force-locked and/or form-locked manner,
wherein the connection region is a threaded region and the cutout is a tapped bore, so that the ventilation means is connectable in the housing part by screwing,
wherein the arrangement has a seal (22) able to be arranged between ventilations means and housing part for the impervious connection of the ventilation means to the housing part, wherein the first and second surface region are in each case a bearing surface (4), in particular a plane bearing surface, for a respective membrane,
wherein the respective membrane (23) is placed on the respective bearing surface and is pressed against the respective bearing surface by an edge region of a respective eye-like ring part (25),
wherein a protective cap (20) rests on a step (8) of a ventilation portion (5).

2. An arrangement according to claim 1,
**characterised in that**
the mouth openings are covered by means of a respective semipermeable membrane.

3. An arrangement according to at least one of the preceding claims,
**characterised in that**
the membranes and/or mouth openings are oriented parallel.

4. An arrangement according to at least one of the preceding claims,
**characterised in that**
the arrangement has a protective cap connectable on the ventilation means in a form-locked and/or force-locked manner.

5. An arrangement according to at least one of the preceding claims,
**characterised in that**
the protective cap is substantially a body of rotation.

6. An arrangement according to at least one of the preceding claims,
**characterised in that**
first and second surface region are arranged in a flattened region, so that first and second surface region are at a distance from the protective cap, in particular from its inner surface, in particular wherein the protective cap is placed on the ventilation means and is connected in a contacting manner, in particular on a ventilation portion in which the flattened region is arranged.

7. An arrangement according to at least one of the preceding claims,
**characterised in that**
the ventilation means is arranged in a cutout of the housing part.

8. An arrangement according to at least one of the preceding claims,
**characterised in that**
the protective cap surrounds the first and second surface region or the mouth regions, wherein the protective cap is at a distance from these regions.

9. An arrangement according to at least one of the preceding claims,
**characterised in that**
the protective cap has a centrally, therefore centrically, arranged cutout.

10. An apparatus having an arrangement according to at least one of the preceding claims,
**characterised in that**
the ventilation means is connected to a housing pat of the apparatus in a form-locked and/or force-locked manner,
wherein the ventilation means can be arranged and/or is connectable in a cutout of a wall of the housing part.

## Revendications

1. Dispositif conçu pour ventiler une zone d'un espace,
ledit dispositif étant doté d'un moyen de ventilation,
ledit moyen de ventilation (3, 21) présentant un canal de ventilation, en particulier une zone formant cavité qui débouche dans ladite zone de l'espace au niveau de sa première région extrême,
ledit canal de ventilation comprenant au moins deux autres régions extrêmes,
une première région, au sein desdites autres régions extrêmes, débouchant dans un orifice d'embouchure dans une première région de la surface du moyen de ventilation,
une seconde région, au sein desdites autres régions extrêmes, débouchant dans un orifice d'embouchure dans une seconde région de la surface dudit moyen de ventilation,
lesdites première et seconde régions de la surface présentant des orientations différentes, c'est-à-dire que les orifices d'embouchure pointent notamment dans des directions différentes,
sachant notamment que lesdites directions sont mutuellement opposées,
le canal de ventilation revêtant la forme d'un T prononcé,
**caractérisé par le fait que**
le canal de ventilation est formé d'un unique alésage longitudinal et d'un unique alésage transversal,
la zone de l'espace étant au moins partiellement délimitée par une partie de boîtier,
le moyen de ventilation étant pourvu d'une zone de liaison par laquelle il peut être relié, par engagement positif et/ou par complémentarité de formes, dans un évidement de la partie de boîtier,
ladite zone de liaison étant une zone filetée, et ledit évidement étant un perçage taraudé, de telle sorte que ledit moyen de ventilation puisse être relié par vissage dans ladite partie de boîtier,
le dispositif étant muni d'une garniture d'étanchement (22) pouvant être interposée entre le moyen de ventilation et la partie de boîtier, en vue d'instaurer une liaison étanche dudit moyen de ventilation avec ladite partie de boîtier,
les première et seconde régions de la surface se présentant respectivement comme une surface d'appui (4),
en particulier comme une surface d'appui plane, affectée à une membrane considérée, ladite membrane considérée (23) étant appliquée sur la surface d'appui respective, et étant pressée contre ladite surface d'appui respective par une région marginale d'une pièce annulaire respective (25) du type oeillet,
sachant qu'un capuchon protecteur (20) repose sur un gradin (8) d'un tronçon de ventilation (5).

2. Dispositif selon la revendication 1,
**caractérisé par le fait que**
les orifices d'embouchure sont recouverts au moyen d'une membrane semi-perméable respective.

3. Dispositif selon au moins l'une des revendications précédentes,
**caractérisé par le fait que**
les membranes et/ou les orifices d'embouchure sont orienté(e)s parallèlement.

4. Dispositif selon au moins l'une des revendications précédentes,
**caractérisé par le fait que**
ledit dispositif est doté d'un capuchon protecteur pouvant être relié au moyen de ventilation, par complémentarité de formes et/ou par engagement positif.

5. Dispositif selon au moins l'une des revendications précédentes,
**caractérisé par le fait que**
le capuchon protecteur se présente, pour l'essentiel, comme un corps de révolution.

6. Dispositif selon au moins l'une des revendications précédentes,
**caractérisé par le fait que**
les première et seconde régions de la surface sont situées dans une zone aplatie, de façon telle que lesdites première et seconde régions de la surface soient espacées par le capuchon protecteur, en particulier par la surface intérieure de ce dernier,
sachant notamment que ledit capuchon protecteur est mis en place sur le moyen de ventilation et est relié avec instauration d'un contact, en particulier sur un tronçon de ventilation sur lequel se trouve ladite zone aplatie.

7. Dispositif selon au moins l'une des revendications précédentes,
**caractérisé par le fait que**
le moyen de ventilation est logé dans un évidement de la partie de boîtier.

8. Dispositif selon au moins l'une des revendications précédentes,
**caractérisé par le fait que**
le capuchon protecteur entoure, respectivement, les régions d'embouchure ou les première et seconde régions de la surface, ledit capuchon protecteur étant situé à distance de ces régions.

9. Dispositif selon au moins l'une des revendications précédentes,
**caractérisé par le fait que**
le capuchon protecteur présente un évidement occupant une position centrale, c'est-à-dire médiane.

10. Appareil équipé d'un dispositif conforme à au moins l'une des revendications précédentes,
**caractérisé par le fait que**
le moyen de ventilation est relié à une partie de boîtier dudit appareil, par complémentarité de formes et/ou par engagement positif,
ledit moyen de ventilation pouvant être placé et/ou relié dans un évidement d'une paroi de ladite partie de boîtier.
